# EUROPEAN PATENT APPLICATION

(11) **EP 4 459 665 A1**
(43) Date of publication of application: **06.11.2024**
(21) Application number: 22915624.5
(22) Date of filing: 01.12.2022
(51) Int. Cl.: H01L 21/304, F26B 9/06

(54) **SUBSTRATE DRYING DEVICE, SUBSTRATE PROCESSING DEVICE, AND SUBSTRATE MANUFACTURING METHOD**

(30) Priority: 27.12.2021 WO PCT/JP2021/048656
(71) Applicant: Daikin Finetech, Ltd., Yamatokoriyama-shi, Nara 639-1031 (JP)
(72) Inventor: DEGUCHI, Yasunori, Yamatokoriyama-shi, Nara 639-1031 (JP); ARAKI, Ai, Yamatokoriyama-shi, Nara 639-1031 (JP); FUTAMATA, Yoshikazu, Yamatokoriyama-shi, Nara 639-1031 (JP)
(74) Representative: Eisenführ Speiser
(86) International application number: PCT/JP2022/044367
(87) International publication number: WO 2023/127393

(57) **Abstract**

A substrate drying device (2A, 2) includes a dry tank (6) in which a plurality of substrates (4) are aligned at a predetermined pitch (P1), a treatment liquid supply part (8, 10) that supplies a treatment liquid (W) to the dry tank (6), an organic solvent supply part (16, 17) that supplies an organic solvent (CV) to the dry tank (6), and an inert gas supply part (18) that supplies an inert gas (N) to the dry tank (6), the dry tank (6) being provided with a substrate support part (34) that supports the plurality of substrates (4), and with an interval securing member (36, 37) driven so as to come proximate to ends (41, 42, 44) of the plurality of substrates (4) supported by the substrate support part (34) and secure an interval between the substrates (4).

## Description

### TECHNICAL FIELD

The present invention relates to a substrate drying device for drying a substrate, a substrate processing device including the same, and a substrate manufacturing method.

### BACKGROUND ART

There is known a substrate drying device in which various substrates (hereinafter, referred to as "substrate") such as semiconductor wafers are treated with a predetermined chemical solution, cleaned with a cleaning solution such as pure water, and then dried (e.g., Patent Document 1).

The substrate drying device of Patent Document 1 is a drying device using so-called marangoni drying. Specifically, after the substrate is immersed in pure water, isopropyl alcohol (hereinafter referred to as "IPA") is added to a water surface to form a thin IPA film. Thereafter, when the substrate is pulled up from the pure water, the IPA film formed on the water surface replaces the pure water adhered to a surface of the substrate, and the IPA on the surface of the substrate evaporates to result in drying the surface of the substrate.

### PRIOR ART DOCUMENT

### PATENT DOCUMENT

Patent Document 1: JP-A-2001-74374

### SUMMARY OF THE INVENTION

### PROBLEMS TO BE SOLVED BY THE INVENTION

However, when a plurality of substrates are subjected to batch processing by the substrate drying device of Patent Document 1, adjacent substrates may be attracted and adhered to each other by surface tension of a liquid. The adhered part is insufficiently dried to prevent the substrate from being uniformly dried. In recent years, since as substrates have decreased thicknesses, a pitch therebetween tends to be narrower, the substrates apt to adhere to each other. Therefore, it can be said that there is room for improvement in uniformly drying a substrate.

Accordingly, an object of the present invention is to provide a substrate drying device, a substrate processing device, and a substrate manufacturing method that enable more uniform drying of a substrate.

### SOLUTIONS TO THE PROBLEMS

In order to achieve the above object, a substrate drying device according to an aspect of the present invention includes: a dry tank in which a plurality of substrates are aligned at a predetermined pitch; a treatment liquid supply part that supplies a treatment liquid to the dry tank; an organic solvent supply part that supplies an organic solvent to the dry tank; and an inert gas supply part that supplies an inert gas to the dry tank, in which the dry tank is provided with a substrate support part that supports the plurality of substrates, and an interval securing member that is driven to come proximate to ends of the plurality of substrates supported by the substrate support part and secure an interval between the substrates.

A substrate processing device according to an aspect of the present invention includes the substrate drying device; and a substrate processing module coupled to the substrate drying device.

A substrate manufacturing method according to an aspect of the present invention includes : supplying a treatment liquid to a dry tank; placing a plurality of substrates in the dry tank at a predetermined pitch, and supporting the plurality of substrates by a substrate support part provided in the dry tank; supplying an organic solvent to the dry tank; securing an interval between the plurality of substrates by bringing an interval securing member provided in the dry tank proximate to ends of the plurality of substrates supported by the substrate support part; discharging the treatment liquid supplied to the dry tank; and supplying an inert gas to the dry tank.

### EFFECTS OF THE INVENTION

According to the present invention, a substrate can be more uniformly dried.

### BRIEF DESCRIPTION OF THE DRAWINGS

Fig. 1A is a perspective view schematically illustrating a substrate processing device according to a first embodiment.
Fig. 1B is a diagram schematically illustrating a longitudinal cross section of a substrate drying device according to the first embodiment.
Fig. 2A is a schematic perspective view of a carrier accommodating a substrate and a substrate support part according to the first embodiment.
Fig. 2B is an enlarged view of a part of an interval securing member according to the first embodiment.
Fig. 3A is a schematic front view illustrating a substrate pressing part and the substrate according to the first embodiment (retracted state).
Fig. 3B is a schematic plan view illustrating the substrate pressing part and the substrate according to the first embodiment (retracted state).
Fig. 4A is a schematic front view illustrating the substrate pressing part and the substrate according to the first embodiment (proximity state).
Fig. 4B is a schematic plan view illustrating the substrate pressing part and the substrate according to the first embodiment (proximity state).
Fig. 5 is a flowchart illustrating an example of a substrate drying method according to the first embodiment.
Fig. 6A is a schematic diagram for explaining the substrate drying method according to the flowchart of Fig. 5.
Fig. 6B is a schematic diagram for explaining the substrate drying method according to the flowchart of Fig. 5.
Fig. 6C is a schematic diagram for explaining the substrate drying method according to the flowchart of Fig. 5.
Fig. 6D is a schematic diagram for explaining the substrate drying method according to the flowchart of Fig. 5.
Fig. 6E is a schematic diagram for explaining the substrate drying method according to the flowchart of Fig. 5.
Fig. 6F is a schematic diagram for explaining the substrate drying method according to the flowchart of Fig. 5.
Fig. 6G is a schematic diagram for explaining the substrate drying method according to the flowchart of Fig. 5.
Fig. 6H is a schematic diagram for explaining the substrate drying method according to the flowchart of Fig. 5.
Fig. 6I is a schematic diagram for explaining the substrate drying method according to the flowchart of Fig. 5.
Fig. 6J is a schematic diagram for explaining the substrate drying method according to the flowchart of Fig. 5.
Fig. 6K is a schematic diagram for explaining the substrate drying method according to the flowchart of Fig. 5.
Fig. 6L is a schematic diagram for explaining the substrate drying method according to the flowchart of Fig. 5.
Fig. 6M is a schematic diagram for explaining the substrate drying method according to the flowchart of Fig. 5.
Fig. 6N is a schematic diagram for explaining the substrate drying method according to the flowchart of Fig. 5.
Fig. 6O is a schematic diagram for explaining the substrate drying method according to the flowchart of Fig. 5.
Fig. 6P is a schematic diagram for explaining the substrate drying method according to the flowchart of Fig. 5.
Fig. 6Q is a schematic diagram for explaining the substrate drying method according to the flowchart of Fig. 5.
Fig. 7 is a flowchart illustrating an example of a substrate drying method according to a second embodiment.
Fig. 8A is a schematic diagram for explaining the substrate drying method according to the flowchart of Fig. 7.
Fig. 8B is a schematic diagram for explaining the substrate drying method according to the flowchart of Fig. 7.
Fig. 8C is a schematic diagram for explaining the substrate drying method according to the flowchart of Fig. 7.
Fig. 8D is a schematic diagram for explaining the substrate drying method according to the flowchart of Fig. 7.
Fig. 8E is a schematic diagram for explaining the substrate drying method according to the flowchart of Fig. 7.
Fig. 8F is a schematic diagram for explaining the substrate drying method according to the flowchart of Fig. 7.
Fig. 9 is a schematic front view illustrating a drive range of an interval securing member according to a modification.

### DETAILED DESCRIPTION

In the following, embodiments according to the present invention will be described in detail with reference to the drawings.

### (First Embodiment)

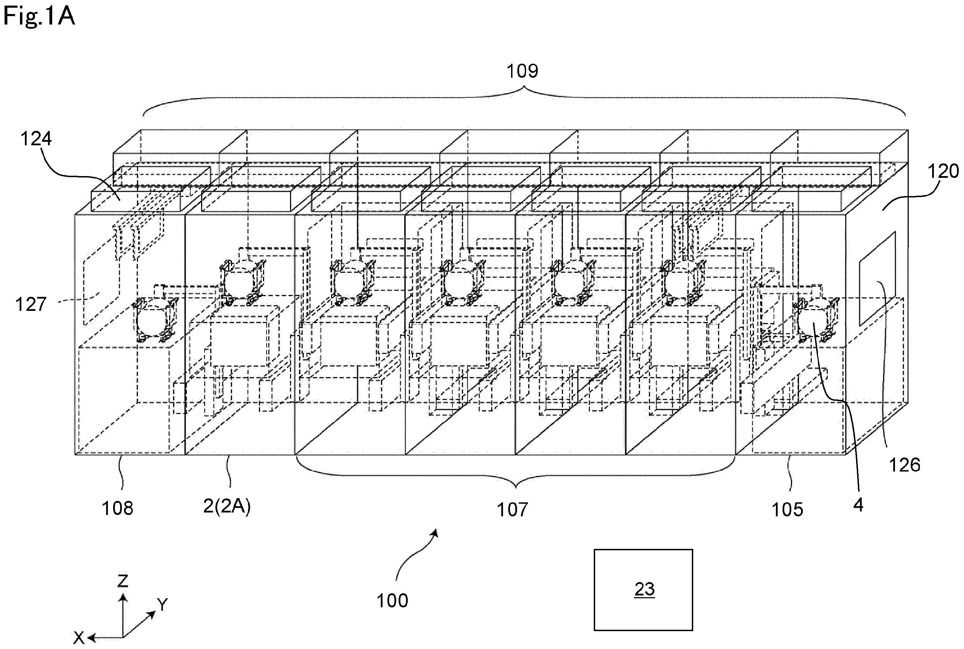

Fig. 1A is a perspective view schematically illustrating a longitudinal cross section of a substrate processing device 100 according to a first embodiment of the present invention.

The substrate processing device 100 includes at least one module for performing various types of processing on a plurality of substrates 4 held by a carrier. Specific examples of the substrate 4 include a semiconductor substrate, a glass substrate for a liquid crystal display device, a glass substrate for a photomask, a substrate for an optical disk, a MEMS sensor substrate, and a solar cell panel. The module has a standardized housing 120, and is configured to be detachable (replaceable) in a second direction (an X-axis direction, which is a longitudinal direction of the substrate processing device 100, hereinafter referred to as "second direction"). A fan filter unit 124 is disposed in an upper part of the module. The fan filter unit 124 includes a fan and a filter for taking in air in a clean room and sending the air into the module. The fan filter unit 124 forms a clean air downflow in a processing space within the module. Instead of disposing the fan filter unit 124, another configuration for taking in clean air in the clean room can be used.

As illustrated in Fig. 1A, the substrate processing device 100 includes, for example, a loading module 105, a chemical module 107 (substrate processing module), a drying module 2 (substrate drying device 2A), an unloading module 108, and a second transport mechanism 109. The loading module 105, the chemical module 107, the drying module 2, and the unloading module 108 are disposed adjacent to each other along the second direction, and are detachably coupled in the second direction. This makes it possible to flexibly cope with a need for changing a processing process, and to enhance expandability.

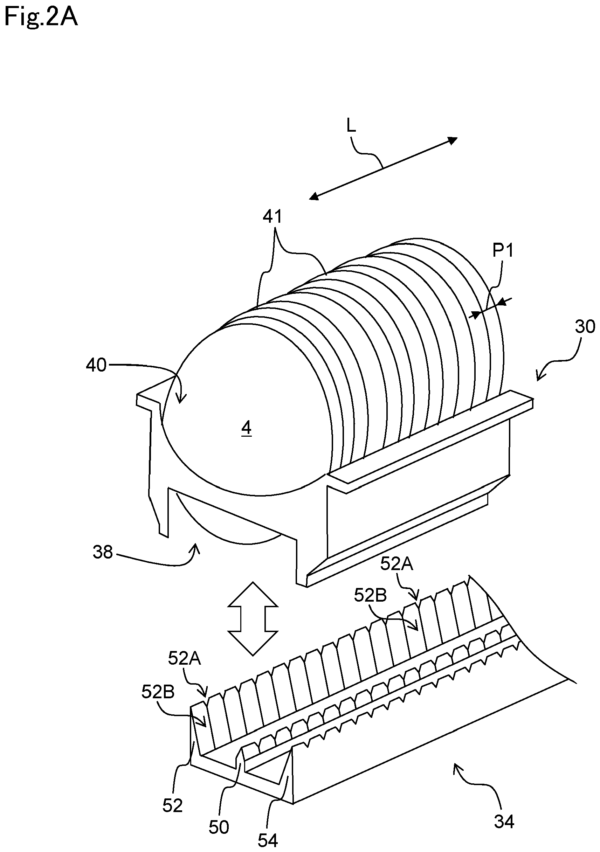

The second transport mechanism 109 extends in the second direction and transports a carrier 30 holding the plurality of substrates 4 illustrated in Fig. 2A in the second direction. The second transport mechanism 109 is disposed above a rear side in a first direction (a Y axis direction, which is a short direction of the substrate processing device 100, hereinafter referred to as "first direction") of the loading module 105, the chemical module 107, the drying module 2, and the unloading module 108.

The substrate processing device 100 includes a controller 23. The controller 23 performs, for example, operation control and data calculation of each element of the substrate processing device 100. The controller 23 includes, for example, a central processing unit (CPU), a random access memory (RAM), and a read only memory (ROM). The CPU executes control according to a program stored in the ROM.

In the loading module 105, the substrate 4 before processing is loaded into the device with the carrier 30 as one unit via a loading part 126. In the chemical module 107, cleaning processing of the substrate 4 is executed using the carrier 30 as one unit. In the drying module 2, for example, drying processing of the substrate 4 by isopropyl alcohol (IPA) or the like is executed using the carrier 30 as one unit. In the unloading module 108, the substrate 4 after the cleaning processing is carried out of the device with the carrier 30 as one unit via the unloading part 127.

In the first embodiment, in particular, the drying module 2 is devised for more uniformly drying the plurality of substrates 4. In the following, the substrate drying device 2A as an example of the drying module 2 will be described.

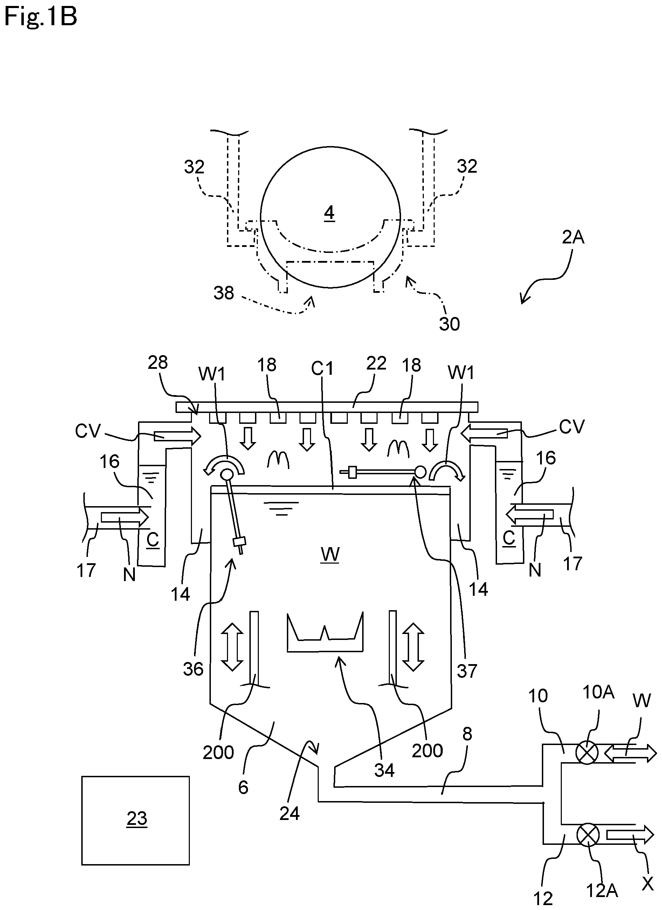

Fig. 1B is a diagram schematically illustrating a longitudinal cross section of the substrate drying device 2A according to the first embodiment.

The substrate drying device 2A illustrated in Fig. 1B is a drying device for drying the plurality of substrates 4 by batch processing. In particular, the substrate drying device 2A dries the plurality of substrates 4 by marangoni drying. As illustrated in Fig. 1B, the substrate drying device 2A includes a dry tank 6, a liquid supply/discharge pipe 8, a treatment liquid supply pipe 10, an exhaust pipe 12, an overflow tank 14, an organic solvent storage tank 16, an inert gas supply part 18, and a lid 22.

The dry tank 6 is a tank for drying the plurality of substrates 4 arranged. The dry tank 6 has an opening 24 formed at a bottom thereof, and the liquid supply/discharge pipe 8 connected through the opening 24. The liquid supply/discharge pipe 8 is a pipe for supplying/discharging a treatment liquid W such as pure water to/from the dry tank 6, and is connected to the treatment liquid supply pipe 10 and the exhaust pipe 12.

The treatment liquid supply pipe 10 is a pipe for supplying/discharging the treatment liquid W to/from the liquid supply/discharge pipe 8. The treatment liquid supply pipe 10 is connected to a supply source for the treatment liquid W (not illustrated).

The exhaust pipe 12 is a pipe for discarding an atmosphere inside the dry tank 6 being not filled with the treatment liquid W. In particular, the exhaust pipe 12 is provided to exhaust an atmosphere X containing a vapor organic solvent (hereinafter, referred to as "organic solvent vapor CV"). The exhaust pipe 12 may be connected to a vacuum source (not illustrated).

The treatment liquid supply pipe 10 and the exhaust pipe 12 are provided with a valve 10A and a valve 12A, respectively. The valves 10A and 12A are controlled to open and close by the controller 23.

The overflow tank 14 is a tank for receiving an overflow amount (treatment liquid W1) of the treatment liquid W supplied to the dry tank 6. The overflow tank 14 is arranged around the dry tank 6.

The organic solvent storage tank 16 is a tank that stores a liquid organic solvent C such as isopropyl alcohol (hereinafter referred to as "IPA"). An inert gas supply pipe 17 is connected to the organic solvent storage tank 16. The inert gas supply pipe 17 supplies an inert gas N such as nitrogen to the organic solvent storage tank 16. By supplying the inert gas N to the organic solvent storage tank 16 and bubbling the liquid organic solvent C, mixed vapor obtained by mixing the inert gas N and the organic solvent vapor CV can be generated. The generated mixed vapor is discharged to a gas phase above the dry tank 6. The organic solvent storage tank 16 and the inert gas supply pipe 17 are organic solvent supply parts that supply the organic solvent vapor CV to the dry tank 6. The organic solvent supply part is not limited to the configuration including the organic solvent storage tank 16 and the inert gas supply pipe 17, and may have any configuration that can supply an organic solvent to the dry tank 6. The organic solvent C and the inert gas N may be heated.

The inert gas supply part 18 is a member for supplying the inert gas N such as nitrogen similarly to the inert gas supply pipe 17 described above. The inert gas supply part 18 discharges the inert gas N to the gas phase above the dry tank 6. The inert gas supply part 18 of the first embodiment forms a plurality of discharge ports provided on a lower surface side of the lid 22. When the inert gas supply part 18 discharges the inert gas N downward in a state where the treatment liquid W in the dry tank 6 is discharged, a surface of the substrate 4 arranged in the dry tank 6 can be dried. The inert gas supply part is not limited to the configuration in which the plurality of discharge ports provided on the lower surface side of the lid 22 are formed, and may have any configuration that can supply the inert gas N to the dry tank 6. For example, a discharge port for discharging the inert gas N may be additionally/alternatively provided at a part different from the lid 22.

The lid 22 is a member that opens and closes an opening part 28 above the dry tank 6, and is provided with the inert gas supply part 18 described above. The lid 22 is detachably attached to the opening part 28, and when the lid 22 covers the opening part 28, an internal space of the dry tank 6 is sealed to the outside.

The controller 23 is electrically connected to each component of the substrate drying device 2A, and controls driving of each component.

In the first embodiment, the plurality of substrates 4 are supplied to the substrate drying device 2A while being held by the carrier 30. The carrier 30 is a member capable of accommodating the plurality of substrates 4 in a state of being aligned, and is held by a substrate transport part 32 having a pair of claws. The substrate transport part 32 integrally transports the carrier 30 and the plurality of substrates 4 contained in the carrier 30.

When the carrier 30 and the plurality of substrates 4 are transported to above the dry tank 6, the carrier 30 can be delivered to a vertical driving part 200 contained in the dry tank 6. When the vertical driving part 200 is raised in a state where the lid 22 is removed, the carrier 30 can be received from the substrate transport part 32, and when the vertical driving part 200 that has received the carrier 30 descends, the carrier 30 and the plurality of substrates 4 are arranged in the dry tank 6 through the opening part 28. Fig. 1B illustrates a state where the substrate transport part 32 holds the carrier 30 before delivering the carrier 30 to the vertical driving part 200.

Although in Fig. 1B, the vertical driving part 200 is exemplified as a plurality of rod-shaped members extending upward, the present invention is not limited to such a configuration, and may have any configuration that allows vertical movement of the carrier 30 upon receiving the same. In the drawings other than Fig. 1B, illustration of the vertical driving part 200 is omitted.

As illustrated in Fig. 1B, the dry tank 6 is further provided with a substrate support part 34 and interval securing members 36 and 37.

The substrate support part 34 is a member that supports the plurality of substrates 4 from below. The substrate support part 34 of the first embodiment includes a plurality of protrusions protruding upward, and abuts on the plurality of substrates 4 through a gap 38 formed in the carrier 30. Here, configurations of the carrier 30 and the substrate support part 34 will be described with reference to Fig. 2A.

Fig. 2A is a schematic perspective view illustrating the carrier 30 in which a plurality of substrates 4 are arranged, and the substrate support part 34. As illustrated in Fig. 2A, the plurality of substrates 4 are arranged and positioned in a groove provided on an inner wall surface of the carrier 30. With main surfaces opposed to each other, the plurality of substrates 4 are aligned at a predetermined pitch P1 with an interval along an alignment direction L orthogonal to the main surfaces.

The substrate 4 has a thickness of, for example, 0.05 mm to 1 mm (preferably 0.3 mm to 0.8 mm), and the pitch P1 is, for example, 2 mm to 8 mm (preferably 3 mm to 7 mm). As the substrate 4, for example, a TAIKO (registered trademark) wafer may be used. The pitch P1 may not be completely constant, and may be different for each combination of the substrates 4. An average pitch of the plurality of substrates 4 may be treated as the pitch P1.

The substrate drying device 2A according to the first embodiment supports a "narrow pitch" i.e., the pitch P1 of 5 mm or less, and can perform marangoni drying using the substrate 4 and the carrier 30 that support the narrow pitch.

The gap 38 is formed on a lower side of the carrier 30, and a gap 40 is formed on an upper side. The substrate 4 is exposed from each of the gaps 38 and 40. The substrate support part 34 can abut on the substrate 4 exposed from the lower space 38. The interval securing members 36 and 37 (not shown in Fig. 2A) shown in Fig. 1B can come proximate to the substrate 4 exposed from the upper space 40.

As illustrated in Fig. 2A, the substrate support part 34 of the first embodiment has three protrusions 50, 52, and 54. Each of the plurality of substrates 4 is supported at three points from below by the protrusion 50 located at the center and the protrusions 52 and 54 located on both sides of the protrusion 50.

As illustrated in Fig. 2A, the protrusion 52 is provided with a plurality of recesses 52A and a plurality of slits 52B. The recess 52A is a recess for receiving an end of the substrate 4, and the plurality of the recesses are provided at equal intervals along the alignment direction L. The slit 52B is a slit continuously formed with the recess 52A, and is provided for each recess 52A and extends downward. The slit 52B has a function of guiding a liquid such as a treatment liquid or an organic solvent flowing from the surface of the substrate 4 downward. The liquid flowing through the slit 52B drops downward from an opening formed between the protrusions 50 and 52. The same two kinds of grooves are formed in the protrusions 50 and 54 (reference numerals and description thereof are omitted).

The substrate support part 34 is not limited to the shape illustrated in Fig. 2A, and may have any shape that can support the substrate 4. For example, not limited to a protrusion protruding upward, a plurality of rod-shaped members extending in a horizontal direction may be used, and the number of the rod-shaped members is not limited to three. In addition, it may have a triangular prism shape, a cylindrical shape, or the like, and may have such a slit as the slit 52B illustrated in Fig. 2A, or may have no slit. A material of the substrate support part 34 may be any material (e.g., PEEK) that has corrosion resistance to an organic solvent. The substrate support part 34 may have a surface hydrophilized or hydrophobized, or may be coated with a fluororesin.

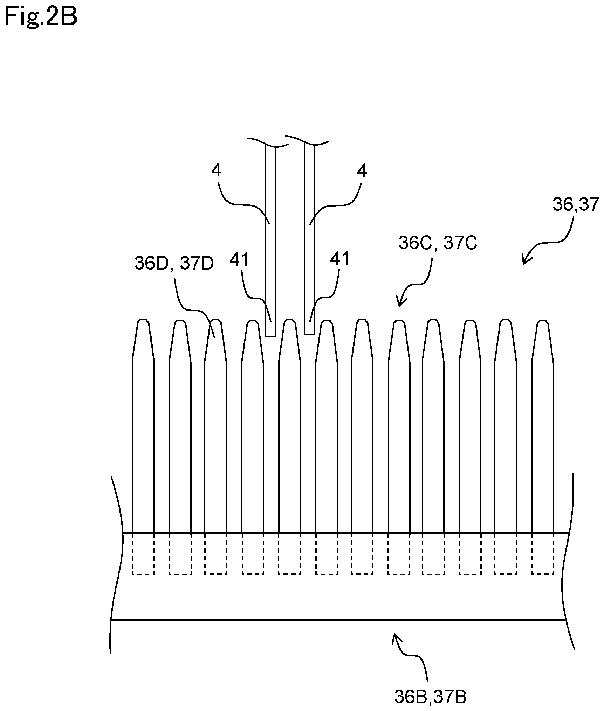

Here, configuration and operation of the interval securing members 36 and 37 illustrated in Fig. 1B will be described with reference to Figs. 2B and 3A to 4B.

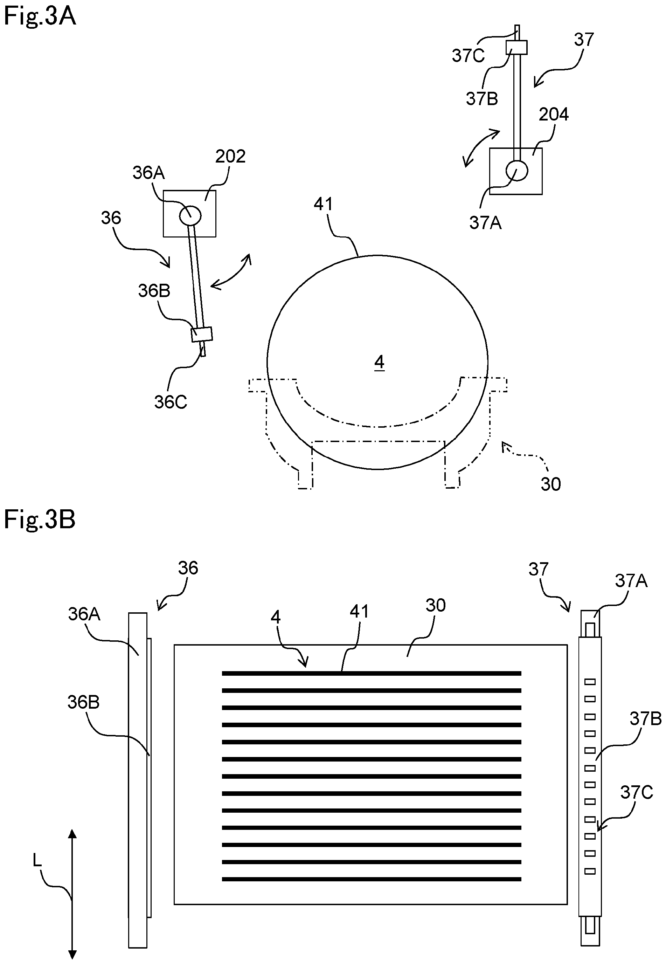

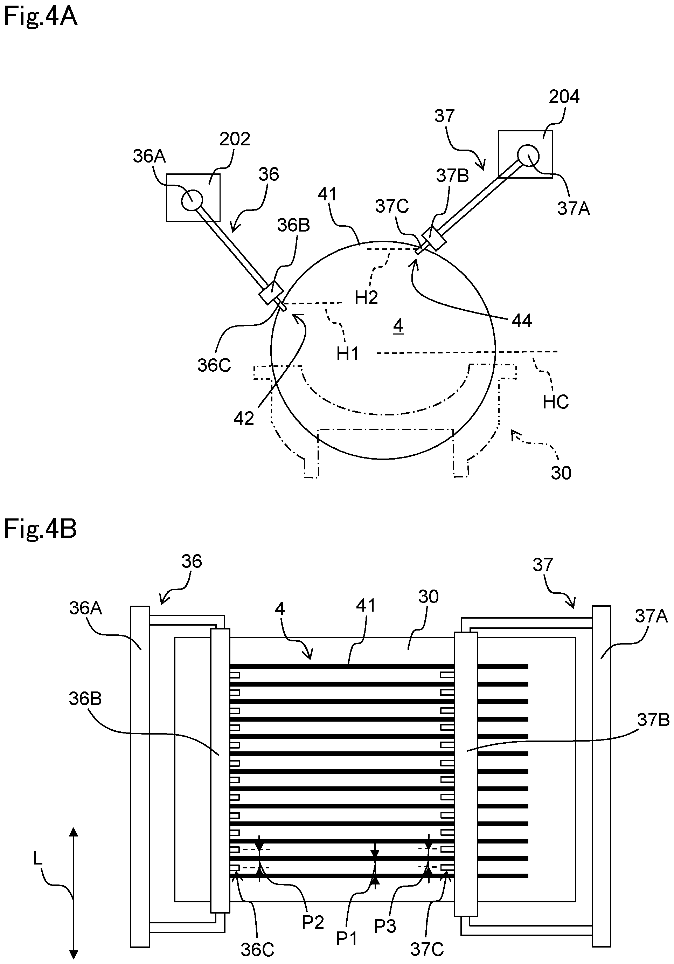

Fig. 2B is a schematic view showing a part of the interval securing members 36 and 37 in an enlarged manner. Figs. 3A and 3B are a schematic front view and a schematic plan view illustrating the interval securing members 36 and 37 and the substrate 4, respectively, and show a "retracted state" in which the interval securing members 36 and 37 are retracted from the substrate 4. Figs. 4A and 4B are a schematic front view and a schematic plan view illustrating the interval securing members 36 and 37 and the substrate 4, respectively, and show a "proximity state" in which the interval securing members 36 and 37 are in proximity to the substrate 4.

As illustrated in Figs. 2B and 3A to 4B, the interval securing members 36 and 37 are members that come proximate to an end 41 of the substrate 4 (i.e., an outer peripheral end surface of the substrate 4) to secure an interval between the substrates 4, and are rotationally driven by driving parts 202 and 204 illustrated in Figs. 3A and 4A, respectively. Since the interval securing members 36 and 37 secure the interval between the plurality of substrates 4, even when the substrates 4 are aligned at a narrow pitch, it is possible to prevent the adjacent substrates 4 from adhering to each other due to the surface tension of the liquid. This facilitates uniform drying of the substrates 4.

In the first embodiment, the first interval securing member 36 and the second interval securing member 37 are provided. Providing the two kinds of the interval securing members 36 and 37 enables themselves to selectively come proximate to different parts of the end 41 of the substrate 4, and to rehold the substrate 4.

Also in the first embodiment, the first driving part 202 for driving the first interval securing member 36 and the second driving part 204 for driving the second interval securing member 37 are separately provided. The driving parts 202 and 204 are configured to include, for example, motors for rotationally driving the interval securing members 36 and 37, respectively. Any configuration may be used for the driving parts 202 and 204 as long as the configuration has a function of rotationally driving the interval securing members 36 and 37. The driving parts 202 and 204 are controlled to operate by the controller 23, and can be operated independently. For example, the controller 23 operates the first driving part 202 to drive the first interval securing member 36 at a predetermined first timing, and operates the second driving part 204 to drive the second interval securing member 37 at a second timing different from the first timing. This enables reholding of the substrate 4.

As illustrated in Figs. 3A to 4B, the first interval securing member 36 has a rotation shaft 36A, a first part 36B, and a second part 36C. Similarly, the second interval securing member 37 includes a rotation shaft 37A, a first part 37B, and a second part 37C.

The first interval securing member 36 is rotationally driven around the rotation shaft 36A, and moves between a retracted position (Figs, 3A, 3B) where the first part 36B and the second part 36C located on distal end sides are retracted from the end 41 of the substrate 4 and a proximity position (Figs. 4A, 4B) where the same come proximate to the end 41 of the substrate 4.

Similarly, the second interval securing member 37 is rotationally driven around the rotation shaft 37A, and moves between the retracted position (Figs, 3A, 3B) where the first part 37B and the second part 37C located on the distal end sides are retracted from the end 41 of the substrate 4 and the proximity position (Figs. 4A, 4B) where the same come proximate to the end 41 of the substrate 4.

As illustrated in Figs. 3B and 4B, the first part 36B of the first interval securing member 36 has a shape extending along the alignment direction L of the substrates 4. A plurality of the second parts 36C having a shape protruding outward from the first part 36B toward the substrate 4 are provided at intervals in the alignment direction L. As illustrated in Fig. 4B, a pitch P2 of the second part 36C is set to be substantially the same as the pitch P1 of the substrate 4. The position is set such that when the plurality of the second parts 36C come proximate to the ends 41 of the substrates 4, each of the second parts 36C is arranged in a gap between the substrates 4.

Similarly, the first part 37B of the second interval securing member 37 has a shape extending along the alignment direction L of the substrates 4. A plurality of the second parts 37C having a shape protruding outward from the first part 37B toward the substrate 4 are provided at intervals in the alignment direction L. A pitch P3 of the second part 37C is set to be substantially the same as the pitch P1 of the substrate 4, and the position is set such that when the second parts come proximate to the ends 41 of the substrates 4, each of the second parts 37C is arranged in the gap between the substrates 4.

As illustrated in Fig. 2B, in the interval securing members 36 and 37 of the first embodiment, the second parts 36C and 37C have a rod-like shape to be inserted into and fixed to the first parts 36B and 37B, respectively. Distal ends 36D and 37D of the second parts 36C and 37C have a tapered shape, and thus, a space between the adjacent distal ends 36D and 37D is widened. The end 41 of the substrate 4 is arranged in this expanded space, and adhesion between the adjacent substrates 4 can be prevented to secure an interval. In Fig. 2B, only two substrates 4 are illustrated for simplification.

The interval securing members 36 and 37 only need to have a function of securing an interval between the substrates 4, and may or may not abut on the end 41 of the substrate 4. Even when the interval securing members 36 and 37 do not abut on the end 41 of the substrates 4, they come into contact with the second parts 36C and 37C of the interval securing members 36 and 37 when the adjacent substrates 4 are about to adhere to each other by surface tension of the liquid. The interval securing members 36 and 37 may be referred to as "substrate pressing part".

The second parts 36C and 37C preferably have a small contact area with the substrate 4, and may have, for example, a needle shape or a conical shape. The second parts 36C and 37C may be, for example, resin-coated on a substrate made of SUS, and may be a resin molded product. The resin may be any resin that can withstand an organic solvent, and examples thereof include fluororesins, PEEK, PP, and PE.

As illustrated in Fig. 4A, the first interval securing member 36 and the second interval securing member 37 come proximate to the ends 41 at different height positions of the substrate 4. The first interval securing member 36 comes proximate to a first end 42 of the substrate 4, and the second interval securing member 37 comes proximate to a second end 44 of the substrate 4. A height position H1 of the first end 42 and a height position H2 of the second end 44 are both set above a center position HC in a height direction of the substrate 4. This makes it possible to bring the interval securing members 36 and 37 proximate to the end 41 of the substrate 4 while easily avoiding interference with the carrier 30. The height position H1 of the first end 42 is set lower than the height position H2 of the second end 44. By making the height positions H1 and H2 of the ends 42 and 44 of the substrate 4 to which the interval securing members 36 and 37 come proximate different from each other, operation is enabled for selectively driving the two interval securing members 36 and 37 according to a height of the treatment liquid W for immersing the substrate 4 to improve drying efficiency. Details will be described later.

Fig. 4A exemplifies a state where both the first interval securing member 36 and the second interval securing member 37 come proximate to the end 41 of the substrate 4. However, the present invention is not limited to such a state, and the interval securing members 36 and 37 can be driven independently using the two driving parts 202 and 204 so as to have different states. For example, one of the two interval securing members 36 and 37 may be brought proximate to the end 41 of the substrate 4, and the other may be separated from the end 41 of the substrate 4.

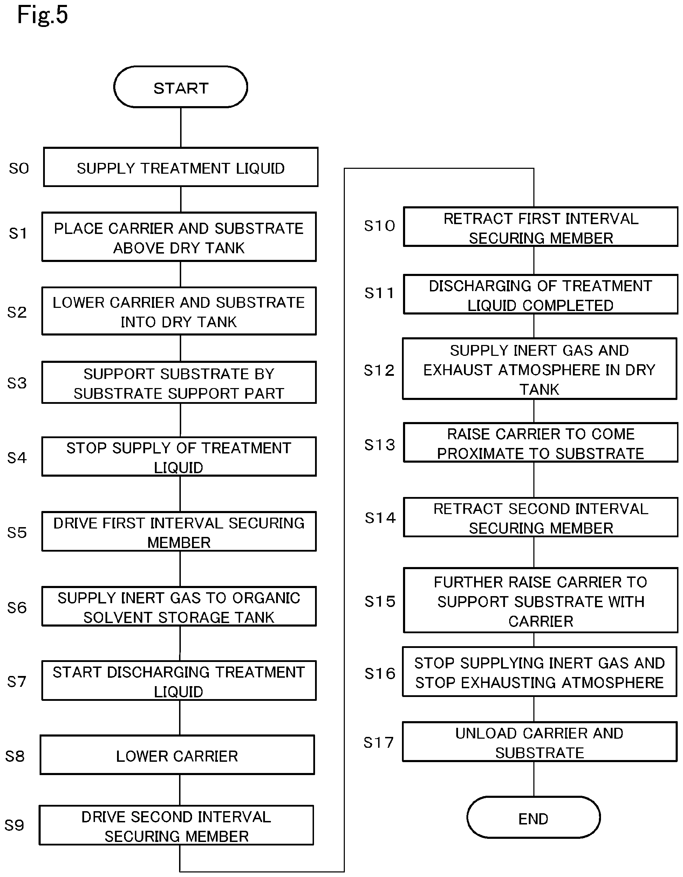

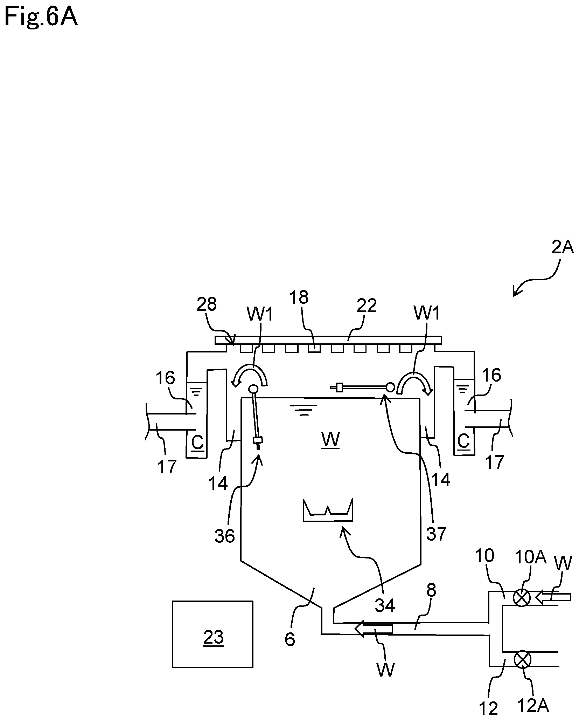

Operation of executing the drying processing of the plurality of substrates 4 using the substrate drying device 2A having the above configuration will be described with reference to Figs. 5 and 6A to 6O. Fig. 5 is a flowchart illustrating an example of a substrate drying method, and Figs. 6A to 6O are schematic diagrams for explaining the substrate drying method according to the flowchart of Fig. 5. Each step illustrated in the flowchart of Fig. 5 is executed under the control of the controller 23, for example.

First, the controller 23 supplies the treatment liquid W (S0). Specifically, as shown in Fig. 6A, the treatment liquid W is supplied to the dry tank 6 through the treatment liquid supply pipe 10 and the liquid supply/discharge pipe 8. Continuous supply of the treatment liquid W results in overflow of the treatment liquid W in the dry tank 6. The overflowed treatment liquid W1 flows into the overflow tank 14. The lid 22 is attached so as to cover the opening part 28. In addition, the second interval securing member 37 being maintained in a horizontal attitude prevents interference with the lid 22, and is not immersed in the treatment liquid W.

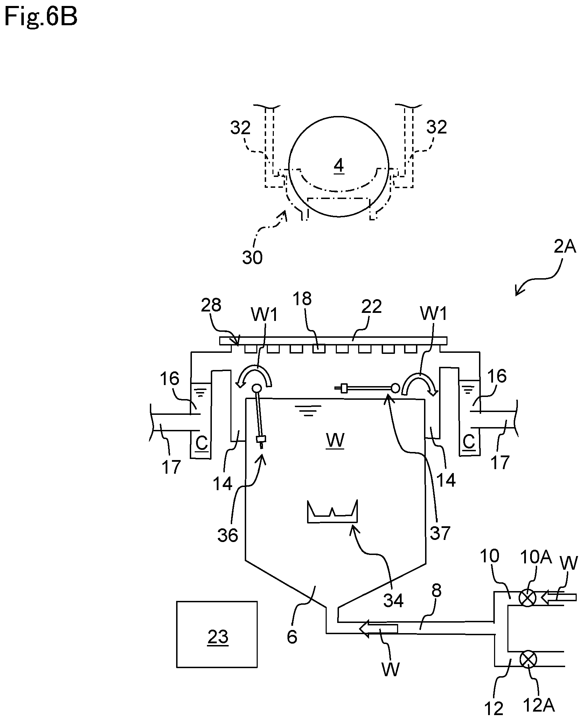

The controller 23 places the carrier 30 and the substrate 4 above the dry tank 6 (S1). Specifically, as illustrated in Fig. 6B, the carrier 30 in a state of accommodating the plurality of substrates 4 is transported by the substrate transport part 32 and located above the lid 22.

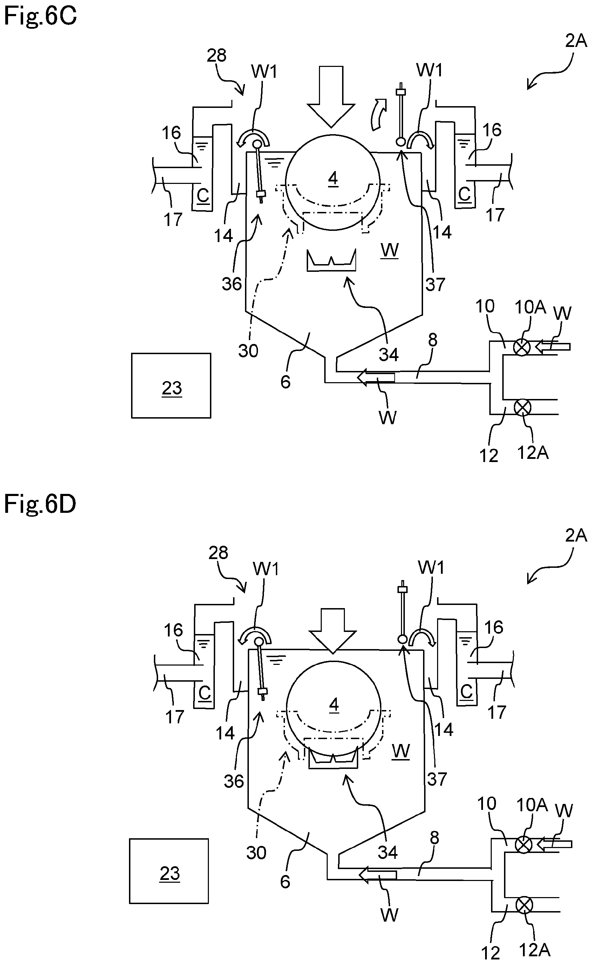

The controller 23 lowers the carrier 30 and the substrate 4 into the dry tank 6 (S2). Specifically, as illustrated in Fig. 6C, the lid 22 is removed to open the opening part 28, and the carrier 30 is delivered to the vertical driving part 200 (see Fig. 1B) (not illustrated) to lower the carrier 30 and the substrate 4. At this time, in order to prevent interference with the carrier 30, the second interval securing member 37 is rotationally driven from the horizontal attitude to a vertical attitude. The carrier 30 and the substrate 4 are immersed in the treatment liquid W in the dry tank 6.

As illustrated in Fig. 6D, the substrate 4 arranged in the dry tank 6 is supported by the substrate support part 34 (S3). Although the support of the substrate 4 by the carrier 30 is released, the carrier 30 is arranged in the vicinity of the substrate 4. The carrier 30 arranged in the vicinity of the substrate 4 exhibits a function of securing a gap between the plurality of substrates 4 until the first interval securing member 36 to be described later is driven.

Although in the first embodiment, exemplified is a case where the substrate support part 34 has a fixed configuration without a function of vertically moving, the substrate support part 34 may vertically move to function as the vertical driving part that vertically moves the substrate 4. In that case, the carrier 30 may be maintained at a predetermined height in the dry tank 6.

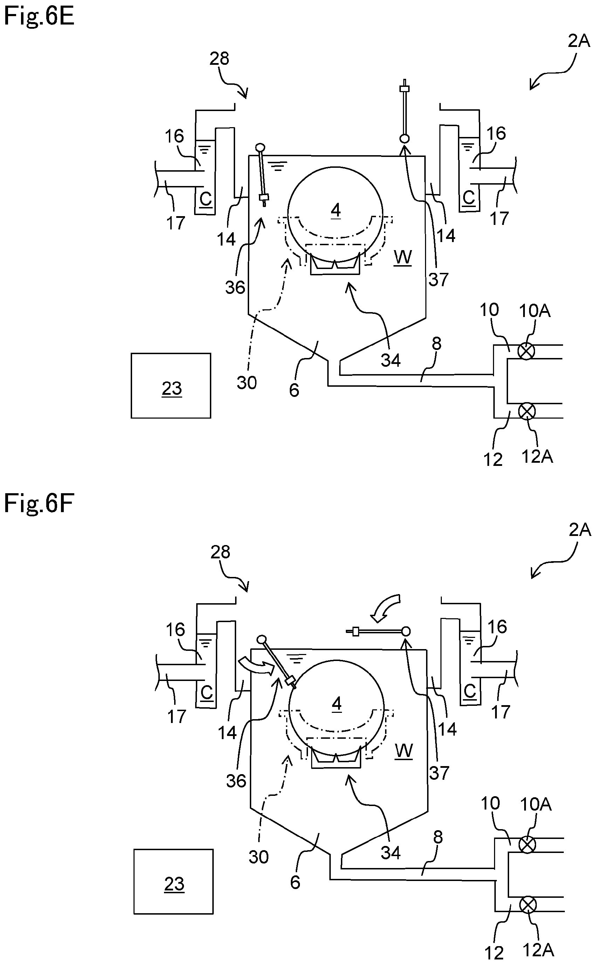

The controller 23 stops the supply of the treatment liquid W (S4). Specifically, as shown in Fig. 6E, the valve 10A of the treatment liquid supply pipe 10 is closed to stop the supply of the treatment liquid W to the dry tank 6.

The controller 23 drives the first interval securing member 36 (S5). Specifically, as illustrated in Fig. 6F, the first interval securing member 36 is rotationally driven to bring the second part 36C of the first interval securing member 36 proximate to the first end 42 of the substrate 4. As illustrated in Fig. 4B, the second part 36C enters the gap between the substrates 4 to maintain the interval between the plurality of substrates 4 and prevent the adjacent substrates 4 from adhering to each other. As a result, it is possible to secure as large an area as possible of the surface of the substrate 4 to be immersed in the treatment liquid W, and to improve uniformity of the drying processing. In addition, even when the carrier 30 is retracted, the interval between the substrates 4 can be secured.

Furthermore, the second interval securing member 37 is rotationally driven to be in the horizontal attitude. As a result, even when the lid 22 is attached to a position covering the opening part 28, the second interval securing member 37 does not interfere, thereby enabling the lid 22 to be attached. Note that in a case where the second interval securing member 37 does not interfere even when the lid 22 is attached, the second interval securing member 37 may be maintained in the vertical attitude and may not be rotationally driven in stages.

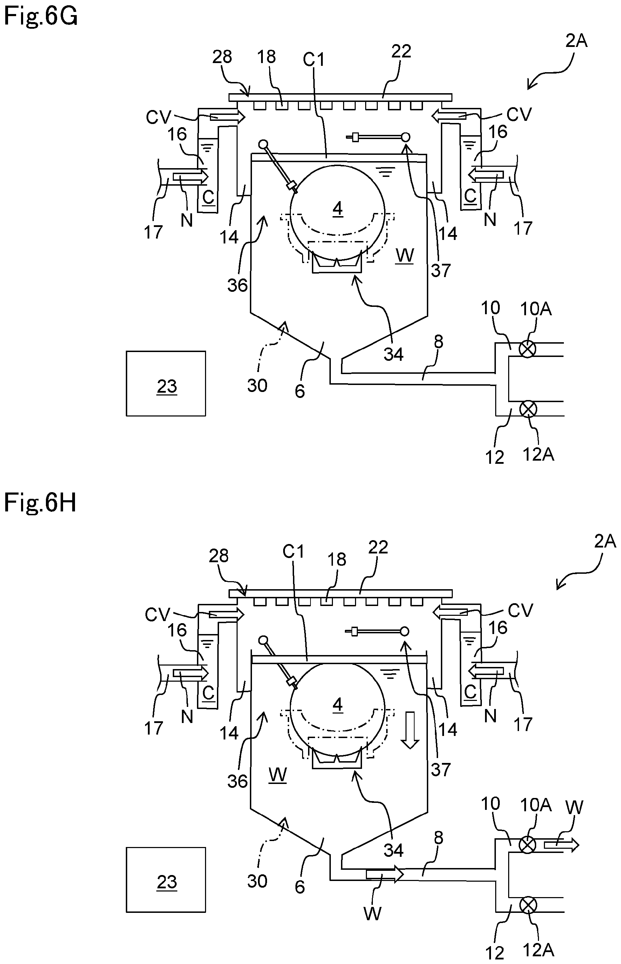

The controller 23 supplies the inert gas N to the organic solvent storage tank 16 (S6). Specifically, as shown in Fig. 6G, the lid 22 is attached so as to cover the opening part 28, and the inert gas N is supplied to the organic solvent storage tank 16 through the inert gas supply pipe 17. As a result, the organic solvent C is bubbled by the inert gas N, and the organic solvent vapor CV, which is a mixed vapor of the inert gas N and the organic solvent C, is generated and supplied to the gas phase of the dry tank 6.

By supplying the organic solvent vapor CV, an organic solvent film C1 is formed on a water surface of the treatment liquid W in the dry tank 6.

The controller 23 starts discharging the treatment liquid W (S7). Specifically, as shown in Fig. 6H, by opening the valve 10A of the treatment liquid supply pipe 10, the treatment liquid W in the dry tank 6 is discharged through the liquid supply/discharge pipe 8 and the treatment liquid supply pipe 10. The treatment liquid W in the dry tank 6 has its liquid level decreased while maintaining a state of the organic solvent film C 1 being formed. When the liquid level of the treatment liquid W decreases, the treatment liquid W is exposed to the outside in order from an upper end of the substrate 4, and subjected to a space filled with the organic solvent vapor CV. On the exposed surface of the substrate 4, the treatment liquid W is replaced with the organic solvent C. Thereafter, the organic solvent C adhering to the surface evaporates, so that the substrate 4 is dried.

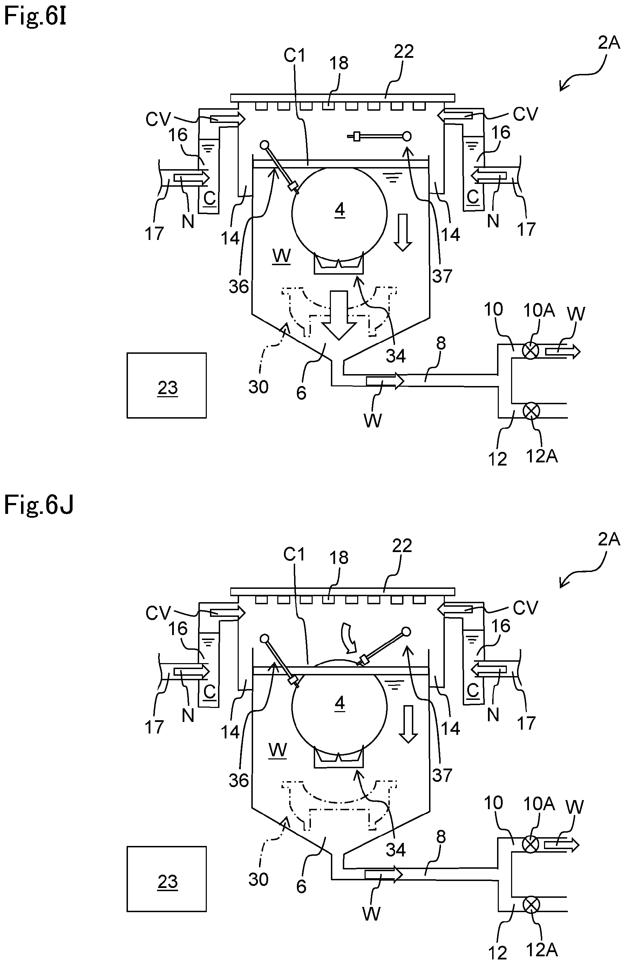

The controller 28 lowers the carrier 30 (S8). Specifically, as shown in Fig. 6I, the carrier 30 is lowered by using the vertical driving part 200 (not shown) as discharging of the treatment liquid W starts. Although the carrier 30 has a function of securing the interval between the substrates 4 being supported by the substrate support part 34, even when the carrier is retracted from the end 41 of the substrate 4 as the first interval securing member 36 comes proximate to the substrate 4, a state where the interval between the substrates 4 is secured can be maintained by the first interval securing member 36.

The controller 23 drives the second interval securing member 37 (S9). Specifically, as illustrated in Fig. 6J, the second interval securing member 37 is rotationally driven to rotate from the horizontal attitude to a position where the second part 37C of the second interval securing member 37 comes proximate to the second end 44 of the substrate 4. As a result, both the first interval securing member 36 and the second interval securing member 37 temporarily come proximate to the end 41 of the substrate 4.

The driving of the second interval securing member 37 in Step S9 is executed at timing when the first end 42 is immersed in the treatment liquid W and the second end 44 is exposed from the treatment liquid W. On a surface of the second end 44 exposed from the treatment liquid W, the treatment liquid W is replaced with the organic solvent C.

As the timing of driving the second interval securing member 37, for example, an arbitrary reference may be adopted, such as when a liquid level sensor (not illustrated) detects the liquid level of the treatment liquid W reaching a predetermined level, or when a predetermined time has elapsed since the start of the discharging (S7) of the treatment liquid W.

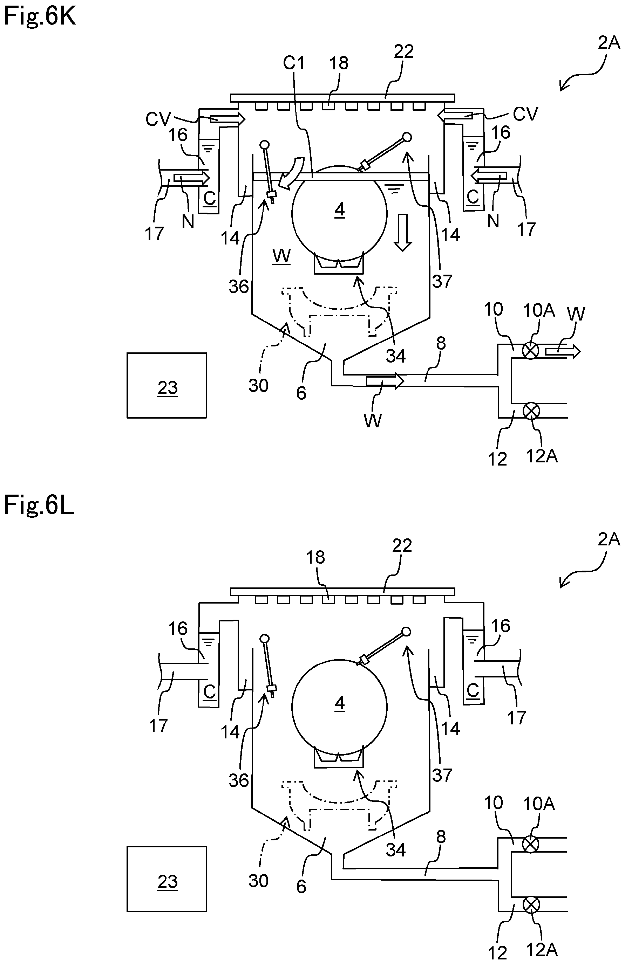

The controller 23 retracts the first interval securing member 36 (S10). Specifically, after the second interval securing member 37 comes proximate to the second end 44 of the substrate 4, as illustrated in Fig. 6K, the first interval securing member 36 is rotationally driven in a direction retracting from the substrate 4. As a result, the interval between the substrates 4 is secured only by the second interval securing member 37 by releasing the securing of the interval between the substrates 4 by the first interval securing member 36. Note that not limited to being lowered in advance at the timing of Step S8, the carrier 30 may be lowered at different timings during the discharging of the treatment liquid W, such as lowered simultaneously with retraction of the first interval securing member 36 in Step S10.

The retraction of the first interval securing member 36 in Step S10 is executed at the timing when the first end 42 is immersed in the treatment liquid W and the second end 44 is exposed from the treatment liquid W, similarly to the driving of the second interval securing member 37 in Step S9. The first end 42 is immersed in the treatment liquid W by retraction of the first interval securing member 36. Thereafter, when the first end 42 is exposed from the treatment liquid W in accordance with the lowering of the liquid level of the treatment liquid W, the treatment liquid W adhering to the first end 42 is also replaced with the organic solvent.

According to the above operation, by bringing at least one of the interval securing members 36 and 37 proximate to the plurality of substrates 4, it is possible to expose both the first end 42 and the second end 44 of the substrate 4 to the treatment liquid W to be replaced with the organic solvent C while maintaining the state where the substrates 4 are spaced apart from each other. As a result, the number of insufficiently dried parts on the surface of the substrate 4 can be reduced, so that the substrate 4 can be easily dried uniformly to improve dry quality of the substrate 4.

As timing of driving the first interval securing member 36, for example, an arbitrary reference may be adopted, such as when the liquid level sensor (not illustrated) detects the liquid level of the treatment liquid W reaching a predetermined level, or when a predetermined time has elapsed since the start of the discharging (S8) of the treatment liquid W, or when a predetermined time has elapsed since the driving (Step S9) of the second interval securing member 37.

Thereafter, as shown in Fig. 6L, the discharging of the treatment liquid W is completed (S11). At this time, the supply of the inert gas N from the inert gas supply pipe 17 is also stopped.

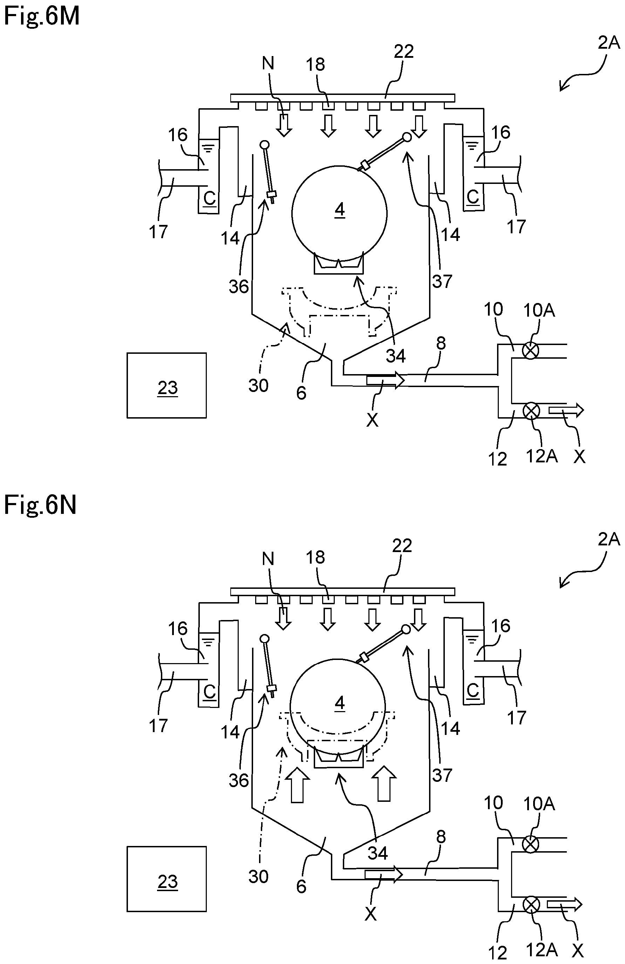

The controller 23 supplies the inert gas N and exhausts the atmosphere X in the dry tank 6 (S12). Specifically, as shown in Fig. 6M, when the treatment liquid W is eliminated from the dry tank 6, the inert gas N is supplied to a space above the dry tank 6 through the inert gas supply part 18, and the valve 12A of the exhaust pipe 12 is opened, so that the atmosphere X in the dry tank 6 is exhausted through the liquid supply/discharge pipe 8 and the exhaust pipe 12.

As a result, a gas containing the organic solvent vapor CV and the organic solvent C evaporating from the surface of the substrate 4 gradually decreases from the inside of the dry tank 6, so that the organic solvent C adhering to the surface of the substrate 4 is removed. As a result, drying of the substrate 4 proceeds.

The controller 23 raises the carrier 30 to come proximate to the substrate 4 (S13). Specifically, as shown in Fig. 6N, while the supply of the inert gas N from the inert gas supply part 18 is continued, the carrier 30 is raised using the vertical driving part 200 (not shown) to come proximate to the substrate 4. While maintaining a state where the substrate 4 is supported by the substrate support part 34, by bringing the carrier 30 proximate to the substrate 4, the carrier 30 is brought to be able to ensure the interval between the substrates 4. As a result, even when the second interval securing member 37 is retracted, the interval between the substrates 4 can be secured.

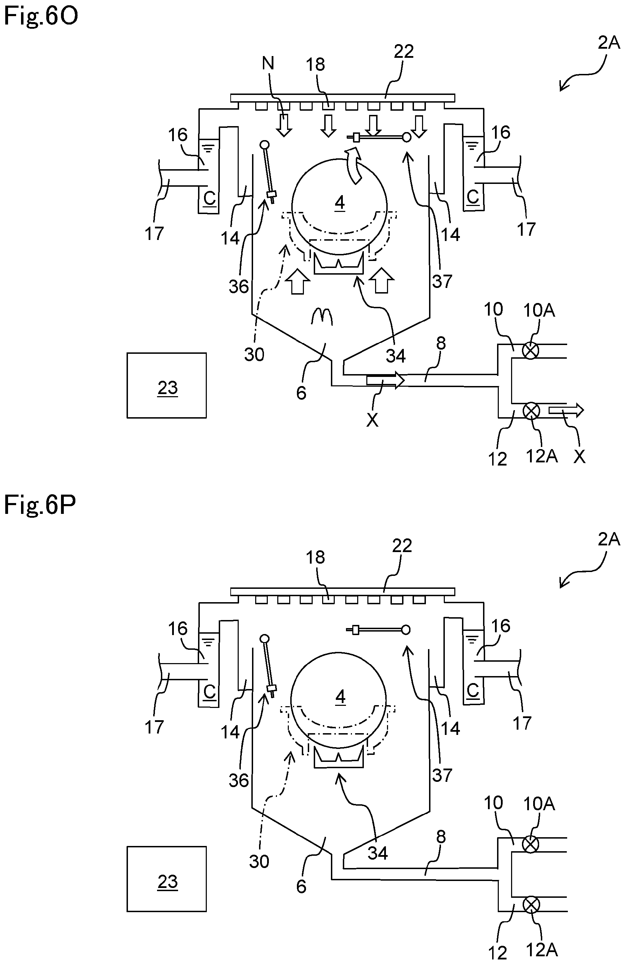

The controller 23 retracts the second interval securing member 37 (S14). Specifically, as illustrated in Fig. 6O, the second interval securing member 37 is rotationally driven in a direction away from the substrate 4 and retracted to the horizontal attitude. In a state where both of the interval securing members 36 and 37 are retracted from the end 41 of the substrate 4, the carrier 30 in proximity to the substrate 4 maintains the interval between the substrates 4.

When the second interval securing member 37 is retracted, the second end 44 of the substrate 4 is exposed. As shown in Fig. 6J, since the second interval securing member 37 is in proximity to the second end 44 after being exposed from the treatment liquid W, replacement with the organic solvent has been completed. By retracting the second interval securing member 37 while exhausting the atmosphere X in the dry tank 6, evaporation of the organic solvent at the second end 44 proceeds to dry the second end 44.

The controller 23 further raises the carrier 30 to support the substrate 4 with the carrier 30 (S15). Specifically, as shown in Fig. 6O, while the supply of the inert gas N from the inert gas supply part 18 is continued, the carrier 30 is further raised using the vertical driving part 200 (not shown). As a result, the support of the substrate 4 by the substrate support part 34 is released to bring the state where the substrate 4 is supported by the carrier 30.

By reholding the substrate 4 from the substrate support part 34 to the carrier 30, it is possible to expose a part of the substrate 4 in contact with the substrate support part 34 (the end 41 arranged in the recess 52A or the like illustrated in Fig. 2A) and dry the part. By the contact with the substrate support part 34, it is possible to dry a part where drying is not in progress, and thus, it is possible to more uniformly dry the entire substrate 4.

The controller 23 stops supplying the inert gas N and stops exhausting the atmosphere X (S16). Specifically, as shown in Fig. 6P, the supply of the inert gas N by the inert gas supply part 18 is stopped, and the exhaust of the atmosphere X is stopped by closing the valve 12A of the exhaust pipe 12, thereby ending the drying processing of the substrate 4.

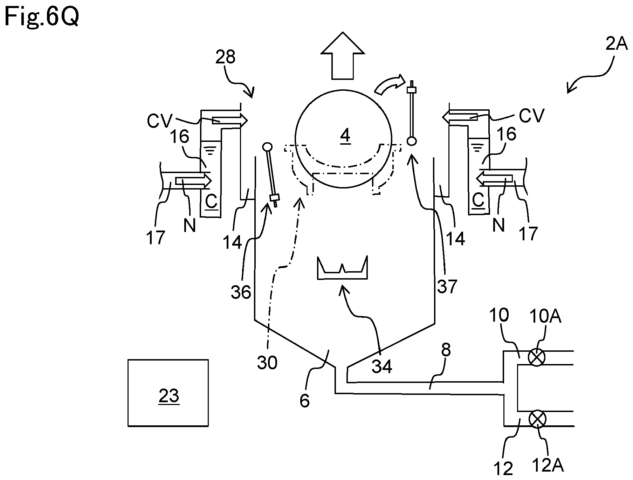

The controller 23 unloads the carrier 30 and the substrate 4 (S17). Specifically, as illustrated in Fig. 6Q, the lid 22 is removed from the opening part 28, the second interval securing member 37 is rotationally driven from the horizontal attitude to the vertical attitude, and then the carrier 30 (not illustrated) accommodating the plurality of substrates 4 subjected to the drying processing is unloaded to the outside of the dry tank 6 using the vertical driving part (not illustrated).

According to the above operation, the plurality of substrates 4 can be dried by batch processing by the marangoni drying method to manufacture the plurality of substrates 4 subjected to the drying processing. In particular, in the substrate drying device 2A of the first embodiment, in the process of discharging the treatment liquid W to dry the substrate 4, the driving is controlled such that at least one of the interval securing members 36 and 37 come proximate to the end 41 of the substrate 4, so that a drying step can be performed in a state where the interval between the substrates 4 is secured. As a result, it is possible to prevent the adjacent substrates 4 from adhering to each other due to the surface tension of the liquid, and thus possible to more uniformly dry the substrates 4. Furthermore, by selectively driving the two interval securing members 36 and 37 to perform reholding the same, the entire surface of the substrate 4 including the ends 42 and 44 to which the interval securing members 36 and 37 come proximate is easily dried, resulting in more uniformly drying the substrate 4. Furthermore, in the middle of the drying by the supply of the inert gas N, the substrate 4 is reheld from the substrate support part 34 to the carrier 30 to continue the drying processing, so that the substrate 4 can be dried including a part in contact with the substrate support part 34, resulting in more uniformly drying the substrate 4.

Thereafter, by arranging the substrates 4 in another batch in the dry tank 6 and executing Steps S1 to S17, the same drying processing can be performed.

### (Operation and Effect of First Embodiment)

As described in the foregoing, the substrate drying device 2A of the first embodiment includes the dry tank 6 in which the plurality of substrates 4 are aligned at the pitch P1 (predetermined pitch), the treatment liquid supply pipe 10 (treatment liquid supply part) that supplies the treatment liquid W to the dry tank 6, the organic solvent storage tank 16 that supplies the organic solvent vapor CV (organic solvent) to the dry tank 6 and the inert gas supply pipe 17 (organic solvent supply part), and the inert gas supply part 18 that supplies the inert gas N to the dry tank 6, in which the dry tank 6 is provided with the substrate support part 34 that supports the plurality of substrates 4, and with the interval securing members 36 and 37 driven so as to come proximate to the ends 41 of the plurality of substrates 4 supported by the substrate support part 34 and secure the interval between the substrates 4.

According to such a configuration, by securing the interval between the substrates 4 by the interval securing members 36 and 37, the drying step can be performed while suppressing adhesion between the substrates 4, thereby easily drying the surface of the substrate 4 uniformly.

In addition, in the substrate drying device 2A according to the first embodiment, the interval securing members 36 and 37 include the first interval securing member 36 that comes proximate to the first ends 42 of the plurality of substrates 4 and the second interval securing member 37 that comes proximate to the second ends 44 of the plurality of substrates 4. According to such a configuration, provision of the two interval securing members 36 and 37 allows reholding of the substrate 4.

In addition, in the substrate drying device 2A according to the first embodiment, the first ends 42 are lower than the second ends 44, and further provided are the first driving part 202 that drives the first interval securing member 36 and the second driving part 204 that drives the second interval securing member 37. According to such a configuration, the interval securing members 36 and 37 that come proximate to the ends 42 and 44 at different heights of the substrate 4 are independently driven, and reholding of the substrate 4 can be performed at an appropriate timing according to a change in the height of the treatment liquid W.

In addition, the substrate drying device 2A according to the first embodiment further includes the controller 23, in which the controller 23 operates the first driving part 202 and the second driving part 204 at different timings. According to such a configuration, reholding of the substrate 4 can be performed at an appropriate timing according to a change in the height of the treatment liquid W.

In addition, the substrate drying device 2A according to the first embodiment further includes the controller 23, in which the controller 23 controls the first interval securing member 36 and the second interval securing member 37 such that the first interval securing member 36 is brought proximate to the first ends 42 (S5: a first interval securing step), the second interval securing member 37 is brought proximate to the second ends 44 in a state where the first interval securing member 36 is in proximity to the first ends 42 (S9: a second interval securing step), and the first interval securing member 36 is retracted from the first ends 42 in a state where the second interval securing member 37 is in proximity to the second ends 44 (S 10: a third interval securing step). According to such control, by reholding the substrate 4 by the two interval securing members 36 and 37, the first ends 42 and the second ends 44 are exposed in the middle of the drying step, and the treatment liquid W including the first ends 42 and the second ends 44 is replaced with the organic solvent C and dried.

In addition, in the substrate drying device 2A according to the first embodiment, the first ends 42 are lower than the second ends 44, and in the process of discharging the treatment liquid W supplied to the dry tank 6, the controller 23 controls the first interval securing member 36 and the second interval securing member 37 so as to bring the first interval securing member 36 proximate to the first ends 42 in a state where both the first ends 42 and the second ends 44 are immersed in the treatment liquid W (S5), to bring the second interval securing member 37 proximate to the second ends 44 in a state where the first ends 42 are immersed in the treatment liquid W and the second ends 44 are exposed from the treatment liquid W (S9), and then to retract the first interval securing member 36 from the first ends 42 (S10). According to such control, by reholding the substrate 4 in the process of discharging the treatment liquid W, the first ends 42 and the second ends 44 of the substrate 4 to which the interval securing members 36 and 37 come proximate can be exposed and dried, so that the entire surface of the substrate 4 including the first ends 42 and the second ends 44 can be easily dried uniformly.

In the substrate drying device 2A according to the first embodiment, the pitch P1 is 5 mm or less. According to such a configuration, in a case where the pitch P1 of the substrates 4 is narrow (in the case of a so-called narrow pitch), while the substrates 4 are liable to adhere to each other, the substrates 4 can be uniformly dried by providing the interval securing members 36 and 37 to execute the drying step while suppressing the adhesion of the substrates 4.

In addition, in the substrate drying device 2A according to the first embodiment, the interval securing members 36 and 37 respectively include the first parts 36B and 37B that extend in the alignment direction L of the plurality of substrates 4 and configured to come proximate to the ends 41 of the plurality of substrates 4, and the plurality of second parts 36C and 37C that protrude from the first parts 36B and 37B and are arranged in the gaps between the plurality of substrates 4. According to such a configuration, adhesion between the substrates 4 can be more reliably prevented.

In addition, in the substrate drying device 2A according to the first embodiment, the plurality of substrates 4 are placed in the dry tank 6 with being contained in the carrier 30, in which the substrate support part 34 comes in contact with the plurality of substrates 4 via the lower space 38 in the carrier 30, and the interval securing members 36 and 37 come proximate to the plurality of substrates 4 via the upper space 40 formed in the carrier 30. According to such a configuration, while it is difficult to dry the entire surface of the substrate 4 in a state where the substrate 4 is contained in the carrier 30, the substrate 4 can be more uniformly dried by executing the drying step while suppressing the adhesion of the substrates 4 by the provision of the interval securing members 36 and 37.

In addition, in the substrate drying device 2A according to the first embodiment, the plurality of substrates 4 are placed in the dry tank 6 with being contained in the carrier 30, in which, in the process of supplying the inert gas N from the inert gas supply part 18 after discharging the treatment liquid W in the dry tank 6 (S12 to S16), the controller 23 performs control to support the plurality of substrates 4 by the substrate support part 34, dry the plurality of substrates 4 in a state where the carrier 30 is retracted (S12: a first drying step), and then to dry the plurality of substrates 4 in a state where the plurality of substrates 4 are reheld from the substrate support part 34 to the carrier 30 (S15: a second drying step). According to such control, it is possible to expose and dry the substrate 4 including a part in contact with the substrate support part 34, and it is thus possible to uniformly dry the entire substrate 4 including a part that is difficult to dry.

In the substrate drying device 2A according to the first embodiment, the ends 41 of the plurality of substrates 4 to which the interval securing members 36 and 37 come proximate are above the center positions HC of the plurality of substrates 4 in the height direction. Such a configuration makes it possible to bring the interval securing members 36 and 37 proximate to the ends 41 of the substrate 4 while easily avoiding interference with the carrier 30.

In addition, the substrate drying device 2A according to the first embodiment further includes the vertical driving part 200 that drives the plurality of substrates 4 to move vertically in the dry tank 6, in which the controller 23 controls the vertical driving part 200 to raise the plurality of substrates 4 supported by the substrate support part 34 to a position separated upward from the substrate support part 34 in the process of supplying the inert gas N from the inert gas supply part 18 after discharging the treatment liquid W in the dry tank 6. According to such a configuration, a part of the substrate 4 in contact with the substrate support part 34 can be exposed for promoted drying, resulting in more uniformly drying the substrate 4.

Furthermore, the substrate processing device 100 according to the first embodiment includes the substrate drying device 2A (drying module 2) and the chemical module 7 (substrate processing module) coupled to the substrate drying device 2A. According to such a configuration, the substrate processing device 100 having high dry quality of the substrate 4 can be realized.

As described in the foregoing, the method for manufacturing the substrate 4 according to the first embodiment includes: supplying the treatment liquid W to the dry tank 6 (S0); placing the plurality of substrates 4 in the dry tank 6 at the pitch P1, and supporting the plurality of substrates 4 by the substrate support part 34 provided in the dry tank 6 (S3); supplying the organic solvent vapor CV (organic solvent) to the dry tank 6 (S6); securing the interval between the plurality of substrates 4 by bringing the interval securing members 36 and 37 provided in the dry tank 6 proximate to the ends 41 of the plurality of substrates 4 supported by the substrate support part 34 (S5, S9, S10); discharging the treatment liquid W supplied to the dry tank 6 (S7 to S11); and supplying the inert gas N to the dry tank 6 (S12). According to such a method, by securing the interval between the substrates 4 by the interval securing members 36 and 37, the drying step can be performed while suppressing adhesion between the substrates 4, thereby easily drying the surface of the substrate 4 uniformly.

### (Second Embodiment)

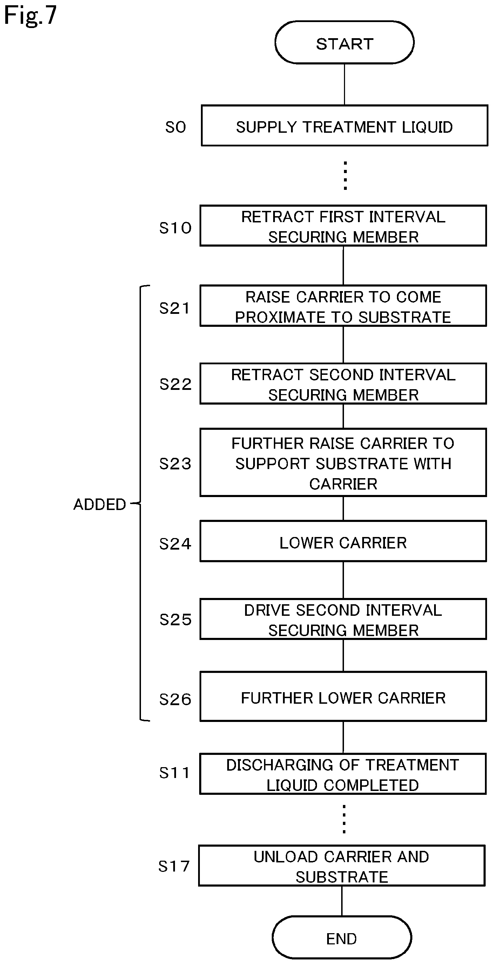

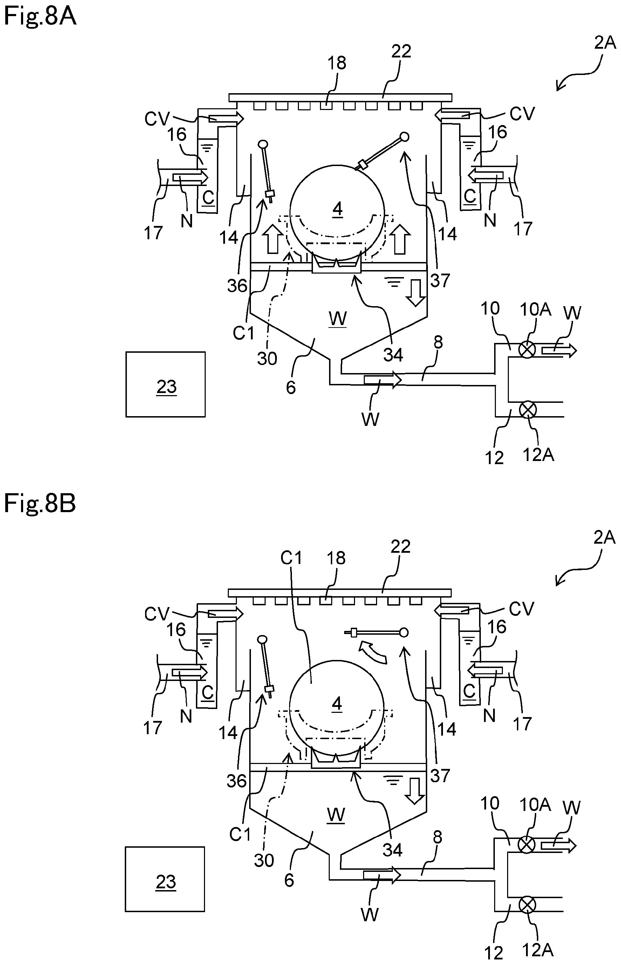

Operation of a substrate drying device 2A according to a second embodiment will be described with reference to Figs. 7 and 8A to 8F. In the second embodiment, the same or similar configurations as those of the first embodiment will be described with the same names and reference numerals applied. In addition, in the second embodiment, description overlapping with the first embodiment will be omitted.

Fig. 7 is a flowchart illustrating an example of a substrate drying method executed by the substrate drying device 2A of the second embodiment, and Figs. 8A to 8F are schematic views for explaining the substrate drying method according to the flowchart of Fig. 7. Each step illustrated in the flowchart of Fig. 7 is executed under the control of the controller 23, for example.

The second embodiment is different from the first embodiment in that the plurality of substrates 4 are temporarily raised from the substrate support part 34 between Steps S10 and S11 among Steps S1 to S17 of the flowchart illustrated in Fig. 5.

As illustrated in Fig. 7, after retracting the first interval securing member 36 in Step S10, the controller 23 raises the carrier 30 to come proximate to the substrate 4 (S21). Specifically, as shown in Fig. 8A, while the discharging of the treatment liquid W and the supply of the organic solvent vapor CV are continued, the carrier 30 is raised using the vertical driving part 200 (not shown) to come proximate to the substrate 4. While maintaining the state where the substrate 4 is supported by the substrate support part 34, by bringing the carrier 30 proximate to the substrate 4, the carrier 30 is brought to be able to ensure the interval between the substrates 4 even when the second interval securing member 37 is retracted.

The controller 23 retracts the second interval securing member 37 (S22). Specifically, as illustrated in Fig. 8B, the second interval securing member 37 is rotationally driven in a direction away from the substrate 4 and retracted to the horizontal attitude. In a state where both of the interval securing members 36 and 37 are retracted from the end 41 of the substrate 4, the carrier 30 in proximity to the substrate 4 maintains the interval between the substrates 4.

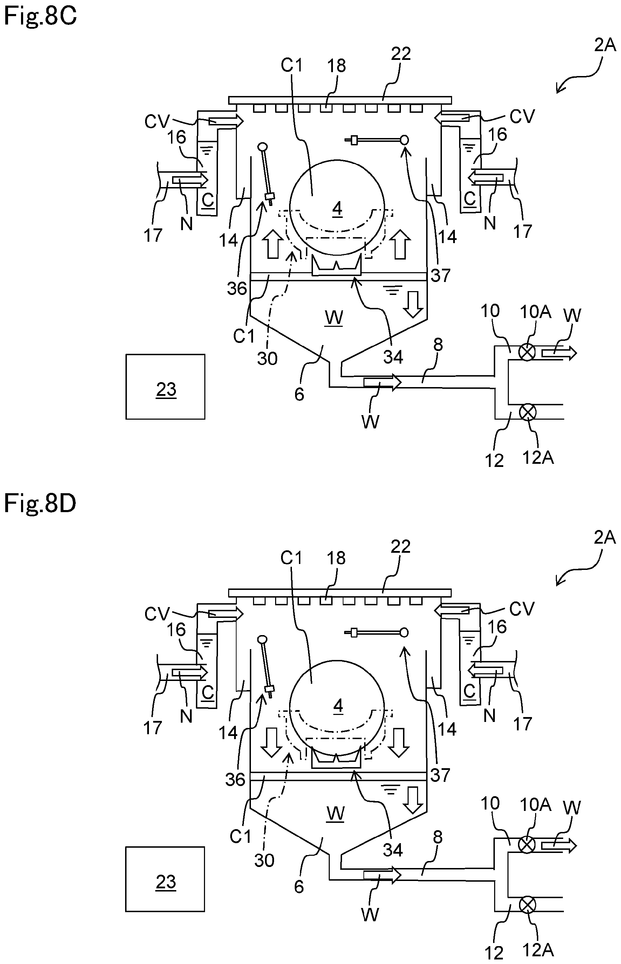

The controller 23 further raises the carrier 30 to support the substrate 4 with the carrier 30 (S23). Specifically, as shown in Fig. 8C, while the discharging of the treatment liquid W and the supply of the organic solvent vapor CV are continued, the carrier 30 is further raised using the vertical driving part 200 (not shown). As a result, the support of the substrate 4 by the substrate support part 34 is released to bring the state where the substrate 4 is supported by the carrier 30. An interval is generated between the substrate support part 34 and the substrate 4 to be in a non-contact state.

By reholding the substrate 4 from the substrate support part 34 to the carrier 30, it is possible to expose a part of the substrate 4 in contact with the substrate support part 34 (the end 41 arranged in the recess 52A or the like illustrated in Fig. 2A) and replace the part with the organic solvent C. By the contact with the substrate support part 34, the organic solvent C can be replaced to a part where the replacement with the organic solvent C hardly proceeds, leading to more uniform drying of the substrate 4. In addition, separating the substrate 4 and the substrate support part 34 from each other also enables the treatment liquid W adhered to the surface of the substrate support part 34 to be replaced with the organic solvent C, and has an effect of preventing the treatment liquid W from being adhered again even when contacting with the substrate 4.

Timing of raising the carrier 30 in Step S23 may be any timing as long as a part of the substrate 4 in contact with the substrate support part 34 is exposed to the organic solvent film C1 or to the organic solvent vapor CV. As a result, replacement with the organic solvent C can be promoted at the corresponding part of the substrate 4.

The controller 23 lowers the carrier 30 (S24). Specifically, as shown in Fig. 8D, while the discharging of the treatment liquid W and the supply of the organic solvent vapor CV are continued, the carrier 30 is further lowered using the vertical driving part 200 (not shown). As a result, the substrate 4 contained in the carrier 30 is supported again by the substrate support part 34. Although the support of the substrate 4 by the carrier 30 is released, the carrier 30 has a function of securing an interval between the plurality of substrates 4 by being arranged in the vicinity of the substrate 4.

A period from Step S23 to Step S24, i.e., a period during which the plurality of substrates 4 are separated upward from the substrate support part 34 may be set to any time that is sufficient to replace the corresponding part of the substrate 4 with the organic solvent C, and may be set within a range of, for example, 30 seconds to 60 seconds.

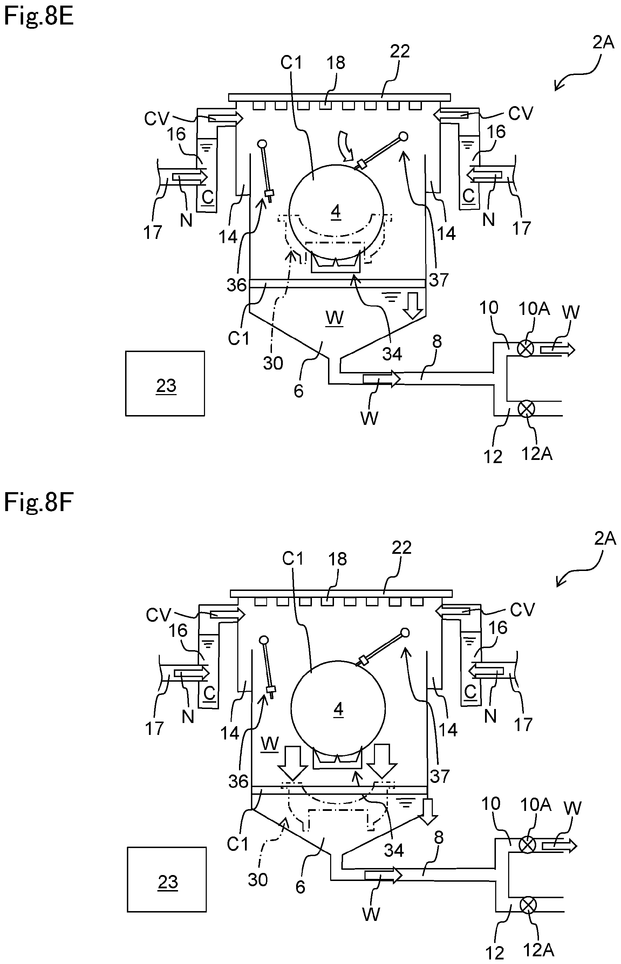

The controller 23 drives the second interval securing member 37 (S25). Specifically, as illustrated in Fig. 8E, the second interval securing member 37 is rotationally driven to rotate from the horizontal attitude to a position where the second part 37C of the second interval securing member 37 comes proximate to the second end 44 of the substrate 4. This brings both the second interval securing member 37 and the carrier 30 to secure the interval between the plurality of substrates 4.

The controller 23 further lowers the carrier 30 (S26). Specifically, as illustrated in Fig. 8F, the carrier 30 is lowered using the vertical driving part 200 (not illustrated) and retracted from the vicinity of the substrate support part 34. As a result, this state can be returned to the state shown in Fig. 6 L, and the discharging of the treatment liquid can be completed (S11). Thereafter, Steps S12 to S17 may be similarly executed to dry the plurality of substrates 4.

Timing of lowering the carrier 30 in Step S26 may be any timing as long as the treatment liquid W is discharged after Step S25.

According to the operation of the second embodiment described above, in the process of discharging the treatment liquid W while supplying the organic solvent vapor CV, by temporarily separating the plurality of substrates 4 supported by the substrate support part 34 from the substrate support part 34 (S23), the part of the substrate 4 in contact with the substrate support part 34 can be exposed to promote the replacement with the organic solvent C.

In the second embodiment, the plurality of substrates 4 are temporarily raised and then lowered to be supported again by the substrate support part 34. As a result, it is possible to return to the state before rising and make smooth transition to the subsequent drying steps (S12 to S16) by the supply of the inert gas N.

Also in the drying steps (S12 to S16) by the supply of the inert gas N, the operation of temporarily raising the plurality of substrates 4 supported by the substrate support part 34 is executed (S15). Therefore, the part of the substrate 4 replaced with the organic solvent C in Step S23 can be exposed and more reliably dried.

In this way, the entire surface of the substrate 4 can be more uniformly dried.

Not limited to the case where the substrate 4 is supported again by the substrate support part 34 before the discharging of the treatment liquid W is completed, the discharging of the treatment liquid may be completed while the substrate 4 remains at a position separated upward from the substrate support part 34, and the processing may proceed to the subsequent drying step by the supply of the inert gas N. In this case, the plurality of substrates 4 are lowered and supported by the substrate support part 34 during execution of the drying step, so that the part of the substrate 4 and the carrier 30 being in contact with each other can be dried.

### (Operation and Effect of Second Embodiment)

The substrate drying device 2A of the second embodiment further includes the vertical driving part 200 that drives the plurality of substrates 4 to move vertically inside the dry tank 6, in which the controller 23 controls the vertical driving part 200 to raise the plurality of substrates 4 supported by the substrate support part 34 to a position separated upward from the substrate support part 34 in the process of discharging the treatment liquid W supplied to the dry tank 6 (S21, S23).

According to such a configuration, the foregoing processing leads to more uniform drying of the entire surface of the substrate 4.

Note that the present invention is not limited to the above embodiments, and can be implemented in various other modes. For example, although in the above embodiments, the case where the plurality of substrates 4 are dried while being contained in the carrier 30 has been exemplified, the present invention is not limited to such a case. For example, there may be a case of so-called "carrierless" in which the plurality of substrates 4 are not contained in the carrier 30. In the carrierless case, the substrate transport part 32 and the vertical driving part 200 may directly contact and grip/support the plurality of substrates 4.

In addition, although in the above embodiment, the case where the two kinds of interval securing members 36 and 37 are provided has been described, the present invention is not limited to such a case, and one or three or more interval securing members may be provided.

Furthermore, although in the above embodiment, the description has been made of the case where pure water is used as the treatment liquid W, and IPA is used as the organic solvent C, the present invention is not limited to such a case, and other types of liquids may be used.

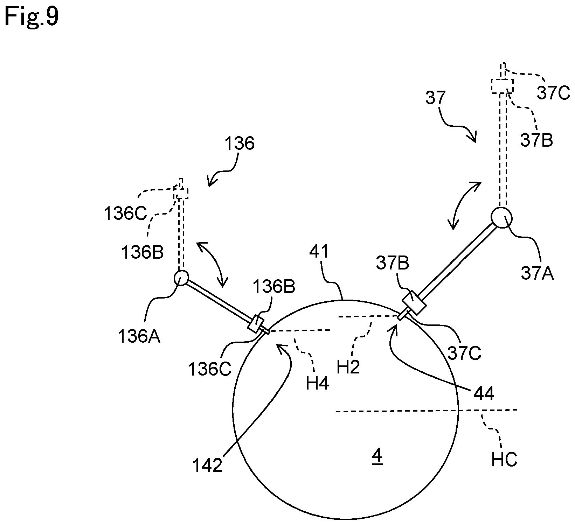

Furthermore, although in the above embodiment, the case where the drive ranges of the interval securing members 36 and 37 are left-right asymmetric has been described, the present invention is not limited to such a case. For example, as illustrated in Fig. 9, a drive range of a first interval securing member 136 may be substantially bilaterally symmetrical with the drive range of the second interval securing member 37. In other words, both the first interval securing member 136 and the second interval securing member 37 move in an upper region of the substrate 4. In Fig. 9, a state where the interval securing members 136 and 37 approach the end 41 of the substrate 4 is indicated by a solid line, and a state where the interval securing members retract from the end 41 of the substrate 4 is indicated by a dotted line.

The first interval securing member 136 illustrated in Fig. 9 includes a rotation shaft 136A, a first part 136B, and a second part 136C. Similarly to the embodiment, a height position H4 of an end 142 of the substrate 4 to which the second part 136C comes proximate and the height position H2 of the end 44 of the substrate 4 to which the second part 37C comes proximate are set at positions higher than the center position HC in the height direction of the substrate 4. In addition, the height position H4 is set lower than the height position H2. In order to make the height positions H4 and H2 different from each other, the interval securing members 136 and 37 may be made different in size and shape from each other. According to the interval securing members 136 and 37 illustrated in Fig. 9, it is possible to execute processing (including reholding of the substrate 4) similar to the processing illustrated in the flowcharts of Figs. 5 and 7.

Note that by appropriately combining arbitrary embodiments among the various embodiments described above, the effects of the respective embodiments can be achieved.

The present invention is applicable to a substrate drying device that dries a plurality of substrates, a substrate processing device including the same, and a substrate manufacturing method.

Although the present invention will be fully described in connection with the preferred embodiments with reference to the accompanying drawings, various changes and modifications will be apparent to those skilled in the art. Such changes and modifications are to be understood as being included within the scope of the present disclosure as set forth in the appended claims.

### EXPLANATION OF REFERENCES

- 2: drying module
- 2A: substrate drying device
- 4: substrate
- 6: dry tank
- 8: liquid supply/discharge pipe (treatment liquid supply part)
- 10: treatment liquid supply pipe (treatment liquid supply part)
- 16: organic solvent storage tank (organic solvent supply part)
- 17: inert gas supply pipe (organic solvent supply part)
- 18: inert gas supply part
- 34: substrate support part
- 36: first interval securing member
- 37: second interval securing member
- 41: end
- 42: first end
- 44: second end
- 100: substrate processing device
- 200: vertical driving part
- 202: first driving part
- 204: second driving part

## Claims

1. A substrate drying device comprising:
a dry tank in which a plurality of substrates are aligned at a predetermined pitch;
a treatment liquid supply part that supplies a treatment liquid to the dry tank;
an organic solvent supply part that supplies an organic solvent to the dry tank; and
an inert gas supply part that supplies an inert gas to the dry tank, wherein the dry tank is provided with a substrate support part that supports the plurality of substrates, and an interval securing member that is driven to come proximate to ends of the plurality of substrates supported by the substrate support part and secure an interval between the substrates.

2. The substrate drying device according to claim 1, wherein the interval securing member includes a first interval securing member that comes proximate to first ends of the plurality of substrates and a second interval securing member that comes proximate to second ends of the plurality of substrates.

3. The substrate drying device according to claim 2, wherein
the first ends are lower than the second ends, and wherein
the substrate drying device further comprises: a first driving part that drives the first interval securing member; and
a second driving part that drives the second interval securing member.

4. The substrate drying device according to claim 3, further comprising a controller,
wherein the controller operates the first driving part and the second driving part at different timings.

5. The substrate drying device according to claim 2, further comprising: a controller,
wherein the controller controls the first interval securing member and the second interval securing member so as to:
bring the first interval securing member proximate to the first ends,
bring the second interval securing member proximate to the second ends in a state where the first interval securing member is in proximity to the first ends, and
retract the first interval securing member from the first ends in a state where the second interval securing member is in proximity to the second ends.

6. The substrate drying device according to claim 5, wherein
the first ends are lower than the second ends, and
in a process of discharging the treatment liquid supplied to the dry tank, the controller controls the first interval securing member and the second interval securing member so as to:
bring the first interval securing member proximate to the first ends in a state where both the first ends and the second ends are immersed in the treatment liquid, and
bring the second interval securing member proximate to the second ends, and then retract the first interval securing member from the first ends in a state where the first ends are immersed in the treatment liquid and the second ends are exposed from the treatment liquid.

7. The substrate drying device according to any one of claims 1 to 6, wherein the predetermined pitch is 5 mm or less.

8. The substrate drying device according to any one of claims 1 to 7, wherein the interval securing member includes a first part that extends in an alignment direction of the plurality of substrates and configured to come proximate to the ends of the plurality of substrates, and a plurality of second parts that protrude from the first part and are arranged in gaps between the plurality of substrates.

9. The substrate drying device according to any one of claims 1 to 8, wherein
the plurality of substrates are placed in the dry tank with being contained in a carrier, and
the substrate support part comes in contact with the plurality of substrates via a lower space of the carrier, and the interval securing member comes proximate to the plurality of substrates via an upper space of the carrier.

10. The substrate drying device according to any one of claims 1 to 9, wherein
the plurality of substrates are placed in the dry tank with being contained in a carrier, and
in a process of supplying the inert gas from the inert gas supply part after discharging the treatment liquid in the dry tank, a controller performs control to dry the plurality of substrates in a state where the plurality of substrates are supported by the substrate support part and the carrier is retracted, and then to dry the plurality of substrates in a state where the plurality of substrates are reheld from the substrate support part to the carrier.

11. The substrate drying device according to any one of claims 1 to 10, wherein the ends of the plurality of substrates to which the interval securing member comes proximate are above a center position of the plurality of substrates in a height direction.

12. The substrate drying device according to any one of claims 1 to 11, further comprising a vertical driving part that drives the plurality of substrates to move vertically in the dry tank,
wherein in a process of discharging the treatment liquid supplied to the dry tank, the controller controls the vertical driving part to raise the plurality of substrates supported by the substrate support part to a position separated upward from the substrate support part.

13. The substrate drying device according to any one of claims 1 to 11, further comprising a vertical driving part that drives the plurality of substrates to move vertically in the dry tank,
wherein in a process of supplying the inert gas from the inert gas supply part after discharging the treatment liquid in the dry tank, the controller controls the vertical driving part to raise the plurality of substrates supported by the substrate support part to a position separated upward from the substrate support part.

14. A substrate processing device comprising:
the substrate drying device according to any one of claims 1 to 13; and
a substrate processing module coupled to the substrate drying device.

15. A substrate manufacturing method comprising:
supplying a treatment liquid to a dry tank;
placing a plurality of substrates in the dry tank at a predetermined pitch, and supporting the plurality of substrates by a substrate support part provided in the dry tank;
supplying an organic solvent to the dry tank;
securing an interval between the plurality of substrates by bringing an interval securing member provided in the dry tank proximate to ends of the plurality of substrates supported by the substrate support part;
discharging the treatment liquid supplied to the dry tank; and
supplying an inert gas to the dry tank.
